# EUROPEAN PATENT APPLICATION

(11) **EP 0 531 805 A1**
(43) Date of publication of application: **17.03.1993**
(21) Application number: 92114581.9
(22) Date of filing: 27.08.1992
(51) Int. Cl.: H01L 21/28, H01L 29/64

(54) **Gate electrode fabrication method**

(30) Priority: 10.09.1991 US 757398
(71) Applicant: MOTOROLA, INC., Schaumburg, IL 60196 (US)
(72) Inventor: Hansell, Gregory L., Tempe, Arizona 85284 (US); Gilbert, James G., Tempe, Arizona 85283 (US); Johnson, Jennifer, Chandler, Arizona 85224 (US)
(74) Representative: Dunlop, Hugh Christopher

(57) **Abstract**

A method of fabricating metal gate electrodes (18) in II-VI and III-V compound semiconductor FETs includes providing a II-VI or III-V compound semiconductor substrate (12) and forming a first portion (16) of a gate electrode (18) thereon. A hardmask (20) is formed on the first portion (16) of the gate electrode (18) and a planarizing dielectric layer (22) is formed on the substrate (12) surface including the hardmask (20) and first portion (16) of the gate electrode (18). The hardmask (20) is then exposed and removed. A second portion (28) of the gate electrode (18) is then formed on the first portion (16).

## Description

### Field of the Invention

This invention pertains, in general, to the semiconductor arts and more particularly to a method of fabricating metal gate electrodes in II-VI and III-V compound semiconductor FETs.

### Background of the Invention

It is well known in the semiconductor art to fabricate II-VI and III-V compound semiconductor FETs. Typically, these FETs are MESFETs wherein gate is disposed directly on a compound semiconductor substrate. The use of these MESFETS is desirable in high frequency RF applications.

Gate electrodes comprising refractory metals are highly desirable for the manufacture of gallium arsenide and other compound semiconductor MESFETs. Refractory metals will withstand substrate activation and other processing steps which require temperatures upwards of 800 degrees centigrade. At these high temperatures, a refractory metal will not decompose or react with a gallium arsenide substrate.

In order to obtain good RF performance, the access resistance of the gate metal must be small. When a gate comprised solely of a refractory metal is employed, gate resistance is relatively large, on the order of 1 to 5 ohms/square. Although gate electrodes solely comprised of refractory metals increase manufacturing yield and control, performance is sacrificed by their use.

Gate resistance may be reduced by stacking a second non-refractory metal portion on top of a refractory metal gate portion following high temperature processing steps. Most commonly, the second metal portion of the gate electrode includes lateral extensions that overlap the refractory gate metal portion thereby forming a T-shaped gate. These lateral extensions are formed on a dielectric layer that also surrounds the refractory gate metal portion. This prohibits shorting between the compound semiconductor substrate and the second metal portion of the gate.

One well known method of forming a T-shaped gate having a refractory metal first portion and a non-refractory metal second portion is disclosed by U.S. Patent Number 4,849,376 entitled "Self-Aligned Refractory Gate Process With Self-Limiting Undercut Of An Implant Mask" issued to Balzan et al. on July 18, 1989. The method disclosed by Balzan et al. includes forming a refractory metal (titanium tungsten) gate portion on a gallium arsenide substrate. A planarizing oxide layer is then formed on the substrate surface and a resist layer is formed on the planarizing oxide layer. The resist and planarizing oxide layers are then etched back below the top surface of the refractory metal gate portion and a non-refractory metal gate portion is formed on the refractory metal gate portion. The non-refractory metal gate portion is formed by a lift-off process.

Although the process taught by Balzan et al. is sufficient for various applications, there are many disadvantages associated therewith. It is extremely difficult to control the thickness of a planarizing oxide after its etchback. Typically, the refractory metal gate portion is extremely thin on an RF MESFET and it is very difficult to etchback the planarizing oxide layer below the top surface of the refractory metal gate portion without going to far. There is practically no margin for error.

The etchback of this process leaves a very thin oxide layer. The lateral extensions of the non-refractory portion disposed over the thin oxide often provides insufficient isolation that increases the gate capacitance of the device. It is desirable that the etched back planarizing oxide layer be thicker and the lateral extensions of the non-refractory metal gate portion be better isolated from the gallium arsenide substrate. Further, the lift-off step is a very low yield process step.

Accordingly, it is highly desirable to have a method of fabricating metal gate electrodes in II-VI and III-V compound semiconductor FETs which enables improved yields, has reduced gate resistance, reduced gate capacitance and enables greater variability on a planarizing oxide etch.

### Summary of the Invention

A method of fabricating metal gate electrodes in II-VI and III-V compound semiconductor FETs includes providing a II-VI or III-V compound semiconductor substrate and forming a first portion of a gate electrode thereon. A hard mask is formed on the first portion of the gate electrode and a planarizing dielectric layer is then formed on the substrate. The hard mask is exposed through the planarizing dielectric layer and is then removed leaving an opening exposing the first portion of the gate electrode. A second portion of the gate electrode is then formed on the exposed first portion.

### Brief Description of the Drawings

FIGS. 1-4 are highly enlarged cross-sectional views of a portion of a MESFET during processing in accordance with the present invention;
FIG. 5 is a highly enlarged cross-sectional view of a portion of a MESFET in accordance with the present invention;
FIGS 6-8 are highly enlarged cross-sectional views of a portion of a MESFET during processing in accordance with the present invention;
FIG. 9 is a highly enlarged cross-sectional view of a portion of a MESFET in accordance with the present invention;
FIGS. 10-12 are highly enlarged cross-sectional views of a portion of a MESFET during processing in accordance with the present invention; and
FIG. 13 is a highly enlarged cross-sectional view of a portion of a MESFET in accordance with the present invention.

### Detailed Description of the Drawings

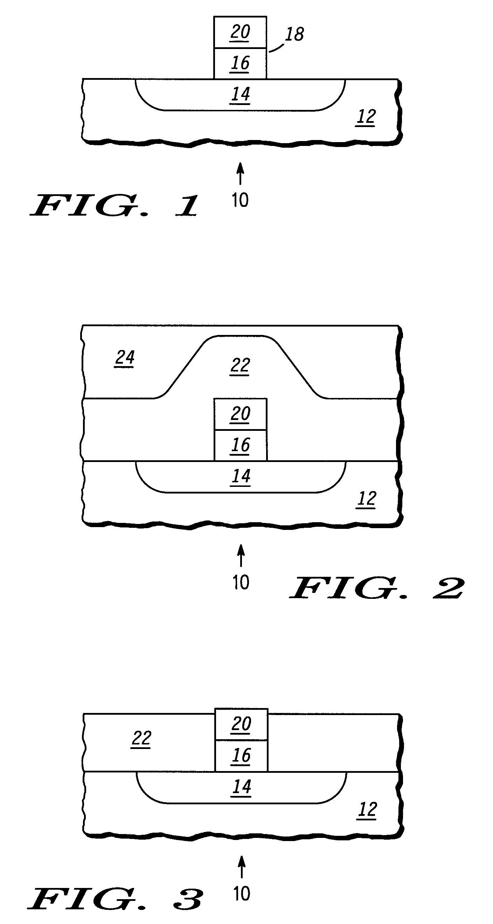

FIGS. 1-4 are highly enlarged cross-sectional views of a portion of a MESFET 10 during processing in accordance with the present invention. MESFET 10 includes a substrate 12. As shown herein, substrate 12 comprises gallium arsenide although the present invention may be employed with substrates comprising other III-V compound semiconductor materials. Additionally, II-VI compound semiconductor substrates may be employed. Substrate 12 includes a doped channel region 14. Channel region 14 may be formed by one of many well known methods including diffusion and implantation. Channel regions such as channel region 14 are well known in the art.

A first portion 16 of a gate electrode 18 is formed on the surface of substrate 12 above channel region 14. First portion 16 of gate electrode 18 comprises a refractory metal or refractory metal mixture. Although tungsten is preferred, materials such as titanium tungsten nitride, titanium nitride, titanium silicide, titanium tungsten silicide, tungsten silicide, tungsten nitride and tungsten silicon nitride may be used. The process depicted herein is a self-aligned gate process. It should be understood that the present invention can also be employed with a non-self-aligned gate process wherein first portion 16 may comprise a non-refractory metal.

A hardmask 20 is disposed on first portion 16 of gate electrode 18. Hardmask 20 may comprise materials such as metalss including refractory metals, nitrides, oxides or oxynitrides. First portion 16 and hardmask 20 are formed by depositing conformal layers on the surface of substrate 12 and then patterning and etching the layers as desired. It should be understood that although a single patterning step may be used, two distinct etching steps will probably have to be employed to etch the different materials of first portion 16 and hardmask 20. Although first portion 16 and hardmask 20 are formed as above, one of skill in the art will understand that they may also be formed separately.

Now referring specifically to FIG. 2. A planarizing dielectric layer 22 is formed over the surface of substrate 12 including first portion 16 and hardmask 20. Planarizing dielectric layer 22 comprises silicon dioxide herein although it may comprise TEOS oxide or other dielectric materials as are well known in the art. Planarizing dielectric layer 22 is typically deposited although other well known methods may be employed for its formation.

Following the formation of planarizing dielectric layer 22, a planarizing material layer 24 is formed on planarizing dielectric layer 22. Layer 24 is typically spun onto layer 22. Layer 24 may comprise photoresist, polyimide, spin-on-glass or other well known planarizing materials. It is important that layer 22 and layer 24 have a substantially 1:1 etch ratio for reasons to be explained presently.

Now referring specifically to FIG. 3. Following the formation of planarizing material layer 24, layers 24 and 22 are etched back to expose hard mask 20. Preferably, planarizing dielectric layer 22 will be etched below the top surface of hard mask 20. The etching of layers 24 and 22 is typically performed by reactive ion etching. As mentioned above, it is important that the etch ratio of layers 24 and 22 be substantially 1:1 so that a uniform etch may be obtained and superior planarity is obtained. When planarizing dielectric layer 22 comprises silicon dioxide, a well known freon and oxygen chemistry may be employed with various well known planarizing materials to provide a planar surface.

The presence of hardmask 20 enables the etching of layers 24 and 22 to be relatively imprecise and allows for a thicker layer 22. Although it is essential that hardmask 20 be exposed, it is not mandatory that the surface of planarizing dielectric layer 22 after the etch be at a particular given height in relation to the top surface of hardmask 20. Further, because layer 22 is not etched to expose first portion 16, it may remain relatively thick. It should be understood that the planarizing dielectric 22 will have a range of desired thickness following the planarizing etch so that gate capacitance of MESFET 10 may be kept relatively small. The final thickness of planarizing dielectric layer 22 may be varied in accordance with specific applications.

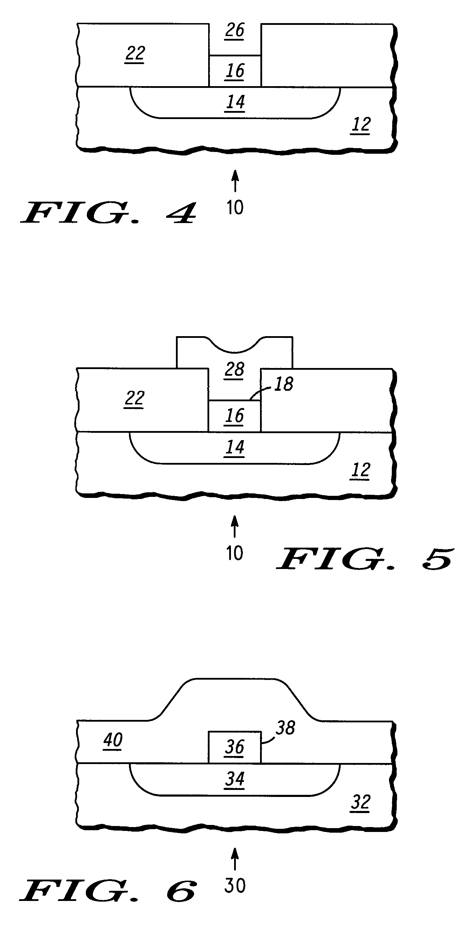

Once planarizing dielectric layer 22 has been etched as desired to expose hardmask 20, hardmask 20 is removed as is depicted by FIG. 4. Hardmask 20 is preferably selectively removed by an etchant that will not significantly affect first portion 16 or planarizing dielectric layer 22. Accordingly, it is desired that hardmask 20 not comprise the same material as first portion 16 of gate electrode 18 or as planarizing dielectric layer 22. An opening 26 is formed in planarizing dielectric layer 22 where hardmask 20 was formerly disposed following its removal. First portion 16 is exposed in opening 26.

During the fabrication of II-VI and III-V compound semiconductor MESFETS such as MESFET 10, the substrate must be activated. In the case of gallium arsenide substrate 12, the activation temperature is often upwards of 800 degrees centigrade. Therefore, it is important that first portion 16 of gate electrode 18 and planarizing dielectric layer 22 be able to withstand high substrate activation temperatures. If substrate 12 is activated prior to the removal of hardmask 20, it is also important the material of which hardmask 20 is comprised be able to withstand the high substrate activation temperatures. This is not necessary if hardmask 20 is removed prior to substrate activation. Refractory metals such as tungsten and tungsten or titanium containing mixtures may be heated to temperatures in excess of 800 degrees centigrade without decomposing or chemically reacting with gallium arsenide substrate 12. Additionally, silicon dioxide used in planarizing dielectric layer 22 will also withstand temperatures in excess of 800 degrees centigrade without decomposing or chemically reacting with gallium arsenide substrate 12 or first portion 16 of gate electrode 18. In the case of a non-self-aligned gate process employing a non-refractory metal first portion 16, other materials may be utilized in association with reduced temperature processing.

FIG. 5 is a highly enlarged cross-sectional view of a portion of MESFET 10 in accordance with the present invention. Once hardmask 20 has been removed, a second portion 28 of gate electrode 18 is formed. As shown, second portion 28 of gate electrode 18 is formed in opening 26 and is coupled to first portion 16 of gate electrode 18. Further, portions of second portion 28 are disposed on planarizing dielectric layer 22 and extend laterally beyond the edges of opening 26. Second portion 28 of gate electrode 18 is formed by depositing a conformal metal layer over planarizing dielectric layer 22 and in opening 26 and then patterning and etching the conformal layer to provide T-shaped second portion 28 as shown. Second portion 28 may comprise one of many well known metals including aluminum, aluminum copper, aluminum silicon copper, gold, titanium tungsten and others.

FIGS. 6-8 are highly enlarged cross-sectional views of a portion of a MESFET 30 during processing in accordance with the present invention. Many features of MESFET 30 are substantially the same as those discussed in conjunction with MESFET 10 earlier and will not be detailed again. MESFET 30 includes a gallium arsenide substrate 32 having a doped channel region 34 therein. A first portion 36 of a gate electrode 38 is formed on the surface of substrate 32 above channel region 34. First portion 36 preferably comprises tungsten and is fabricated by forming a conformal tungsten layer on the surface of substrate 12 and patterning and etching the conformal layer to obtain first portion 36. A planarizing dielectric layer 40 is formed over the surface of substrate 32 including first portion 36. Planarizing dielectric layer 40 comprises silicon dioxide herein.

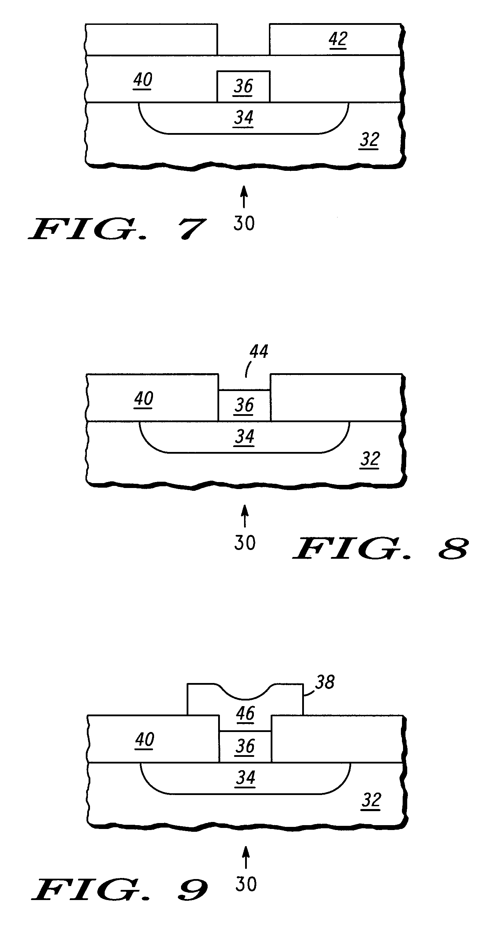

Now referring specifically to FIG. 7. Planarizing dielectric layer 40 is etched back to have a planar topography. This may be done by methods well known in the art. Again, the preciseness of the planarizing etch is not absolutely essential as long as a portion of planarizing dielectric layer 40 remains disposed above first portion 36 following the planarizing etch. Once planarizing dielectric layer 40 has been planarized, a photoresist layer 42 is formed thereon and patterned so that an opening may be formed through planarizing dielectric layer 40 to first portion 36 of gate electrode 38. Although patterned photoresist layer 42 is shown substantially aligned above first portion 36, it should be understood that exact alignment is not mandatory.

Now referring specifically to FIG. 8. An opening 44 is formed in planarizing dielectric layer 40 and exposes the upper surface of first portion 36. Opening 44 may be formed by one of many well known etch methods. Following the formation of opening 44, photoresist 42 is removed. Either prior to the formation of photoresist 42 or after its removal from MESFET 30, substrate 32 may be activated. As discussed earlier, this activation occurs at temperatures in excess of 800 degrees centigrade. Therefore, it is again important that first portion 36 of gate electrode 38 and planarizing dielectric layer 40 be able to withstand these high substrate activation temperatures.

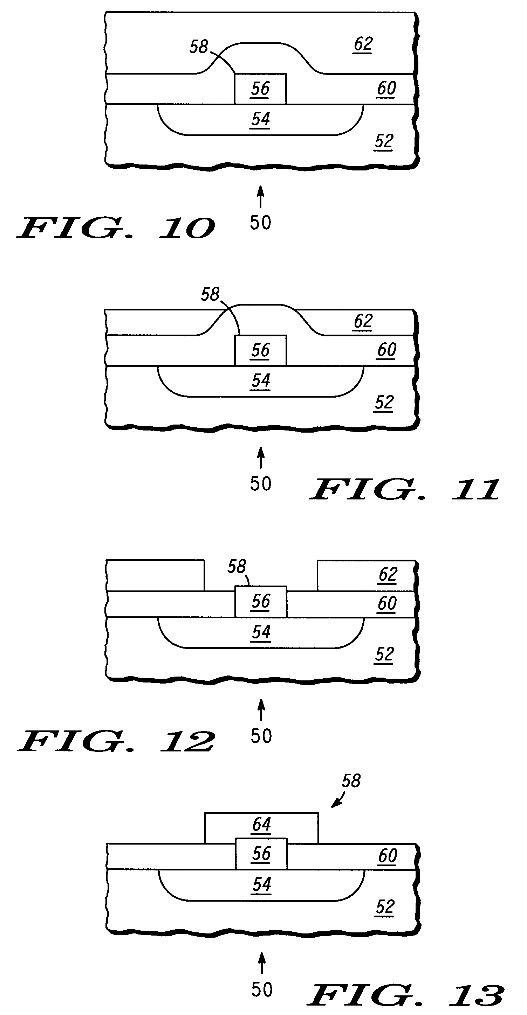

FIG. 9 is a highly enlarged cross-sectional view of a portion of MESFET 30 in accordance with the present invention. Following the formation of opening 44 and the activation of substrate 32, a second portion 46 of gate electrode 38 is formed in opening 44 and on portions of planarizing dielectric layer 40 adjacent opening 44. Second portion 46 is formed by depositing a conformal metal layer over the surface of planarizing dielectric layer 40 and in opening 44 and then patterning and etching to produce T-shaped second portion 46.

FIGS. 10-12 are highly enlarged cross-sectional views of a portion of a MESFET 50 during processing in accordance with the present invention. Many features of MESFET 50 are the same or similar to those of MESFETs 10 and 30 discussed above and will not be set forth again. MESFET 50 includes a substrate 52 comprising gallium arsenide herein. A doped channel region 54 is formed in substrate 52. A first portion 56 of a gate electrode 58 is formed on substrate 52 above channel region 54. First portion 56 comprises tungsten herein and is preferably formed by depositing a conformal tungsten layer on substrate 52 and etching first portion 56 therefrom. Although not shown herein, an optional hardmask may be formed on first portion 56. A dielectric layer 60 comprising silicon dioxide herein is formed on the surface of substrate 52 including first portion 56. A photoresist layer 62 is formed over dielectric layer 60.

Now referring specifically to FIG. 11. Photoresist layer 62 is selectively etched to expose dielectric layer 60. Preferably, photoresist layer 62 is etched below the portion of dielectric layer 60 disposed on first portion 56. An oxygen chemistry may be employed to selectively etch photoresist layer 62 without damaging dielectric layer 60.

Now referring specifically to FIG. 12. The exposed portion of dielectric layer 60 disposed above first portion 56 is etched to expose first portion 56. A fluorine species chemistry may be used to etch dielectric layer 60 without significantly damaging first portion 56 or photoresist layer 62. As shown, the surface of dielectric layer 60 is beneath the top surface of first portion 56. This is not mandatory and is dependent upon the original thickness of dielectric layer 60 and the amount which the portion of dielectric layer 60 above first portion 56 is etched.

FIG. 13 is a highly enlarged cross-sectional view of a portion of MESFET 50 in accordance with the present invention. Following the removal of photoresist layer 62, a second portion 64 of gate electrode 58 is formed on first portion 56. Second portion 64 is formed by patterning and etching a conformal metal layer that has been formed on dielectric layer 60 and first portion 56. Again, second portion 64 laterally extends beyond first portion 56 giving gate electrode 58 a T-shaped configuration.

The structures depicted in FIGS. 5, 9 and 13 and the fabrication methods described herein have substantial advantages over the prior art. First, MESFETS 10, 30 and 50 are fabricated by relatively simple and inexpensive processes. The gate resistance of MESFETs 10, 30 and 50 is relatively small because second portions 28, 46 and 64 of gate electrodes 18, 38 and 58 respectively do not comprise refractory metals. Further reducing gate resistance are the T-shaped configurations of second portions 28, 46 and 64 laterally extending beyond first portions 16, 36 and 56 of gate electrodes 18, 38 and 58. The gate capacitance of MESFETS 10 and 30 is reduced due to the increased thickness of planarizing dielectric layers 22 and 40. Planarizing dielectric layers 22 and 40 may be kept relatively thick because their planarizing etch does not require that they be etched to expose first portion 16 or 36 of gate electrode 18 and 38 respectively. The thicker oxide further keeps the laterally extending portions of second portions 28 and 46 of gate electrodes 18 and 38 further away from the surfaces of substrates 12 and 32 to further reduce gate capacitance.

The processes described herein enable much more latitude on the planarization etch. Because planarizing dielectric layers 22 and 40 are not etched to expose first portion 16 and 36 respectively, it is not of substantial concern that planarizing dielectric layers 22 and 40 become too thin. The only requirement is that the etch of planarizing dielectric layers 22 and 40 allow the layers to remain above the upper surface of first portions 16 and 36. Additionally, the processes disclosed herein require no lift-off process to fabricate second portions 28 and 46 thereby eliminating a host of commonly encountered lift-off problems.

## Claims

1. A method of fabricating metal gate electrodes (18) in II-VI and III-V compound semiconductor FETs comprising the steps of:
providing a II-VI or III-V compound semiconductor substrate (12);
forming a first portion (16) of a gate electrode (18) on said substrate (12); the invention being characterized by:
forming a hard mask layer (20) on said first portion (16) of said gate electrode (18);
forming a planarizing dielectric layer (22) on said substrate (12) wherein said hard mask layer (20) is exposed;
removing said hard mask layer (20); and
forming a second portion (28) of said gate electrode (18) on said first portion (16).

2. The method of claim 1 wherein the first portion (16) of the gate electrode (18) comprises refractory metal.

3. The method of claim 2 wherein the first portion (16) of the gate electrode (18) comprises tungsten or a tungsten or titanium containing mixture.

4. The method of claim 3 wherein the hard mask layer (20) comprises a refractory metal or refractory metal mixture, a non-refractory metal or non-refractory metal mixture, a nitride, an oxide or an oxynitride.

5. A method of fabricating a metal gate electrode (18) in a III-V compound semiconductor FET comprising the steps of:
providing a gallium arsenide substrate (12) to have a gate electrode (18) formed thereon; the invention being characterized by:
forming a first gate metal layer (16) on said substrate (12), said first gate metal layer (16) comprising a refractory metal or refractory metal mixture;
forming a hard mask layer (20) on said first gate metal layer (16);
patterning and etching said first gate metal layer (16) and said hard mask layer (20) to form a first gate portion (16) having a hard mask (20) thereon;
forming a planarizing dielectric layer (22) on said substrate (12) including said first gate portion (16) and said hard mask (20);
planarizing said planarizing dielectric layer (22) to expose said hardmask (20);
selectively removing said hardmask (20) without significantly affecting said first gate portion (16) or said planarizing dielectric layer (22);
forming a second gate metal layer (28) on said first gate portion (16) and said planarizing dielectric layer (22); and
patterning and etching said second gate metal layer (28) to form a second gate portion (28).

6. The method of claim 7 further comprising the steps of forming a resist layer (24) on the planarizing dielectric layer (22) and etching away said resist layer (24) while planarizing said planarizing dielectric layer (22).

7. A method of fabricating a metal gate electrode (38) in II-VI or III-V compound semiconductor FETs comprising the steps of:
providing a II-VI or III-V compound semiconductor substrate (32);
forming a first portion (36) of a gate electrode (38) on said substrate (32); the method characterized by:
forming a planarizing dielectric layer (40) on said substrate (32) including said first portion (36) of said gate electrode (38);
forming an opening (44) in said planarizing dielectric layer (40) exposing said first portion (36) of said gate electrode (38); and
forming a second portion (46) of said gate electrode (38) in said opening (44).

8. A method of fabricating a metal gate electrode (58) in II-VI and III-V semiconductor FETs comprising the steps of:
providing a II-VI or III-V compound semiconductor substrate (52);
forming a first portion (56) of a gate electrode (58) on said substrate (52);
forming a dielectric layer (60) on said substrate (52) including said first portion (56) of said gate electrode (58);
forming a photoresist layer (62) on said dielectric layer (60);
etching said photoresist layer (62) to expose a portion of said dielectric layer (60) disposed above said first portion (56) of said gate electrode (58);
etching said exposed portion of said dielectric layer (60) to expose said first portion (56) of said gate electrode (58); and
forming a second portion (64) of said gate electrode (58) on said exposed first portion (56).
